# EUROPEAN PATENT APPLICATION

(11) **EP 4 625 830 A1**
(43) Date of publication of application: **01.10.2025**
(21) Application number: 24167832.5
(22) Date of filing: 29.03.2024
(51) Int. Cl.: H04B 1/401, H04B 5/77, H04B 5/72, G06K 7/10

(54) **RADIOFREQUENCY DEVICE WITH THREE OPERATING MODES**

(71) Applicant: STMicroelectronics International N.V., 1228 Plan-les-Ouates, Geneva (CH)
(72) Inventor: SVETE, Tilen, 1215 MEDVODE (SI)
(74) Representative: Cabinet Beaumont

(57) **Abstract**

The present disclosure relates to a radiofrequency device (4) comprising an IQ downconverter (304, 306) configured, in first and second operating modes, to mix a received radiofrequency signal (sigRF) with a first periodic signal (LOI) having a frequency equal to a carrier frequency of the received signal (sigRF) and with a second periodic signal (LOQ) in quadrature with the first periodic signal (LOI). The radiofrequency device further comprises a gain controllable amplifier (602) configured, in a third operating mode, to provide an amplified signal (sigA) of the received radiofrequency signal (sigRF), and a mixer (604) configured, in the third operating mode, to mix the amplified signal (sigA) with itself.

## Description

### Technical field

The present disclosure relates generally to electronic circuits, and, in particular embodiments, to a radiofrequency device with three operating modes.

### Background art

Communication systems using a radiofrequency field to exchange data between two electronic devices are known. An example of such devices uses the near field communication (NFC) technologies.

In such a system, when two devices communicate with each other, a first device emits an electromagnetic radiofrequency field and operates in terminal unit mode, the second device receiving the electromagnetic field and operates in card mode or in card emulation mode if this second device is also able to operates in terminal unit mode. The two devices modulate the radiofrequency field to exchange data.

In particular, the first device outputs a carrier field, which means an electromagnetic field at a carrier frequency, on which it produces a modulation to send data to the second device. For example, the first device uses Amplitude Shift Keying (ASK) modulation or On-Off keying (OOK) modulation to modulate the emitted carrier. The second device then sends back data to the first device by retro-modulating the carrier field with a subcarrier signal representative of the data. Thus, in a first operating mode, the first device extracts data from the subcarrier signal on top of the carrier field. This first operating mode is, for example, called "terminal unit reader mode".

When the first device is not in communication with a second device, the functions and/or the circuits of the first device may be placed in standby mode or low power mode for reducing the energy consumption between periods of use. Reducing the energy consumption is advantageous, in particular when the first device is powered by battery, for example when the first device is a mobile phone. Thus, in a second operating mode, the first device periodically checks whether a second device is within the range of the first device, in order to reactivate its functions and circuits for establishing a communication between the two devices when the second device is detected. In the second operating mode, the first device periodically emits the radiofrequency the carrier field and detects whether or not the phase and/or the amplitude of emitted field is modified above a threshold, indicating that a second device is within the range of the first device. This second operating mode is, for example, called "tag detection mode".

In recent system, the first device, for example a mobile phone, is also configured to operate as a card. For example, the second device, or a third device, which acts as a terminal unit, emits the carrier field, and modulates the carrier field to send data to the first device. In order to extract the received data, in a third operating mode, the first device has to decode the modulation of the carrier fields. This third operating mode is, for example, called "card emulation mode".

Known radiofrequency devices capable of alternatively operating in each of the three operating modes described above have drawbacks.

### Summary of Invention

There is a need to overcome at least some of the drawbacks of known radiofrequency devices capable of operate in each of the three operating modes described above.

One embodiment addresses all or some of the drawbacks of known radiofrequency devices capable of operate in each of the three operating modes described above.

One embodiment provides a radiofrequency device comprising:
a first mixer configured, in first and second operating modes, to mix a received radiofrequency signal with a first periodic signal having a frequency equal to a frequency of a carrier of the received radiofrequency signal;
a second mixer configured, in the first and second operating modes, to mix the received radiofrequency signal with a second periodic signal having a frequency equal to the frequency of the carrier and being in quadrature with first periodic signal;
a gain controllable amplifier configured, in a third operating mode, to provide an amplified signal of the received radiofrequency signal; and
a third mixer configured, in the third operating mode, to mix the amplified signal with itself.

According to one embodiment, the first operating mode is a reader mode, preferably a terminal unit reader mode, the second operating mode is a tag detection mode, and the third operating mode is a card emulation mode.

According to one embodiment, the radiofrequency device further comprises:
a first circuit configured, in the second operating mode, to apply a first DC component to an output signal of the first mixer;
a fourth mixer configured, in the second operating mode, to mix an output of the first circuit with a third periodic signal having a frequency equal to a chopping frequency;
a second circuit configured, in the second operating mode, to apply a second DC component to an output signal of the second mixer; and
a fifth mixer configured, in the second operating mode, to mix an output of the second circuit with the third periodic signal.

According to one embodiment, the radiofrequency device further comprises:
a first reconfigurable analog filter configured to:
   - apply a bandpass filtering to the output of the first mixer in the first operating mode and to an output of the fourth mixer in the second operating mode, and
   - apply a lowpass filtering to an output of the third mixer in the third operating mode; and
a second analog filter configured to apply a bandpass filtering to the output of the second mixer in the first operating mode and to an output of the fifth mixer in the second operating mode.

According to one embodiment, the radiofrequency device further comprises:
a first analog-to-digital converter configured to provide a first digital signal resulting from an analog-to-digital conversion of an output of the first analog filter;
a second analog-to-digital converter configured to provide a second digital signal resulting from an analog-to-digital conversion of an output of the second analog filter;
a first reconfigurable digital filter configured to:
   - apply a bandpass filtering to the first digital signal in the first and second operating modes, and
   - apply a lowpass filtering to the first digital signal in the third operating mode; and
a second digital filter configured to apply a bandpass filtering to the second digital signal.

According to one embodiment, the first and second analog-to-digital converters are configured to operate at a same sampling frequency in the first, second and third operating modes, for example less or equal to twice the frequency of the carrier.

According to one embodiment, the radiofrequency device further comprises:
a first control circuit configured, in the first and second operating modes, to control a gain of the first configurable analog filter and a gain of the second analog filter, based on the output of the first configurable digital filter and an output of the second digital filter; and
a second control circuit configured, in the third operating mode, to control a gain of the gain controllable amplifier based on the output of the first configurable digital filter.

According to one embodiment, the radiofrequency device further comprises a digital decoding circuit configured to:
perform a subcarrier Amplitude Shift Keying decoding of the received radiofrequency signal based on the output signal of the first reconfigurable digital filter and the output signal of the second digital filter in the first operating mode;
indicate whether or not a radiofrequency device is detected based on the output signals of the first and second digital filters in the second operating modes; and
perform at least one among an On-Off Keying decoding and an Amplitude Shift Keying decoding of the received radiofrequency signal based on the output signal of the first reconfigurable digital filter in the third operating mode.

According to one embodiment, the second analog filter is further configured to apply the bandpass filtering to the output of the third mixer in the third operating mode.

According to one embodiment:
the second analog filter is further configured to apply the bandpass filtering to the output of the third mixer in the third operating mode; and
the second digital filter is further configured to apply the bandpass filtering to the second digital signal in the third operating mode.

According to one embodiment:
the second analog filter is further configured to apply the bandpass filtering to the output of the third mixer in the third operating mode;
the second digital filter is further configured to apply the bandpass filtering to the second digital signal in the third operating mode; and
the digital circuit is further configured to perform a subcarrier Amplitude Shift Keying decoding of the received radiofrequency signal based on the output signals of the first and second digital filters in the third operating mode.

According to one embodiment, the frequency of the carrier is 13.56 MHz.

According to one embodiment, the chopping frequency is 847.5 kHz.

According to one embodiment, the radiofrequency device further comprises a circuit configured, in the third operating mode, to extract a clock signal from the amplified signal.

One other embodiment provides a mobile phone comprising the radiofrequency device defined above.

### Brief description of drawings

The foregoing features and advantages, as well as others, will be described in detail in the following description of specific embodiments given by way of illustration and not limitation with reference to the accompanying drawings, in which:
Figure 1 is a very simplified representation in the form of blocks of an example of radiofrequency communication system of the type to which the embodiments which will be described apply as an example;
Figure 2 illustrates an example of a radiofrequency device capable of operating in each of the three operating modes previously described;
Figure 3 illustrates an example embodiment of a radiofrequency device capable of operating in each of the three operating modes previously described; and
Figure 4 illustrates in the form of blocks an example of a detailed embodiment of a decoding digital circuit of the device of Figure 3.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements. In particular, although the case of two similar electronic devices, for example mobile or cellular phones, is assumed, all that will be described more generally applies to any electronic device capable of operating in each of the three operating modes previously described. Furthermore, although the case of an electronic device implementing the three operating modes previously described using the NFC technologies is described, all what is described more generally applies to any electronic device implementing these three operating modes using a radiofrequency carrier field emitted by a terminal unit but a technology different from the NFC technologies.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 % or 10°, and preferably within 5 % or 5°.

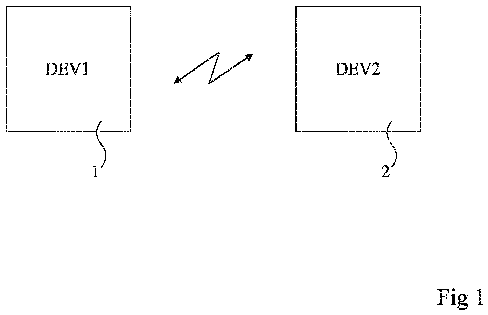

Figure 1 is a very simplified representation in the form of blocks of an example of radiofrequency communication system of the type to which the embodiments which will be described apply as an example.

The communication system of Figure 1, for example a near filed communication system, includes two radiofrequency devices 1 (block DEV1 in Figure 1) and 2 (block DEV2 in Figure 1), that are capable of communicating with each other by near field electromagnetic coupling. For a communication between devices 1 and 2, one of the devices operates in so-called terminal unit mode (or reader mode) while the other device operates in so-called card mode. Each device includes various electronics circuits for generating a radiofrequency signal, which may be transmitted using an antenna. The emitted radiofrequency field is received by the other device is which is located in range and which also includes an antenna.

Each device comprises an oscillating or resonating circuit formed of the antenna (inductive element) and of capacitive element to detect an electromagnetic field. The voltage recovered across the resonant circuit is processed by electronic circuits of the device, in some case to extract power from the received radiofrequency field, and, more generally, to decode data transmitted by the terminal unit via a modulation of the electromagnetic field.

The oscillating circuits are generally tuned to a same nominal frequency called the carrier frequency. The carrier frequency is, for example, equal to 13.56 MHz.

A communication between devices 1 and 2 where the device 1 acts as a terminal unit and emits the radiofrequency field is considered as an example.

During such a communication, a transmission of data from the device 1 to the device 2 is performed by the device 1 by modulating the phase and/or the amplitude of the carrier field. Still during such a communication, a transmission of data from the device 2 to the device 1 is performed by the device 2 by modulating the load formed by the device 2 on the filed radiated by the device 1, the latter interpreting (demodulating) this load variation. In this last case, the device 1 operates in terminal unit reader mode.

A communication between devices 1 and 2 where the device 1 acts as a terminal unit and emits the radiofrequency field is considered as another example.

During such a communication, a transmission of data from the device 2 to the device 1 is performed by the device 21 by modulating the phase and/or the amplitude of the carrier field. The device 1 then extract the data from the received modulated field. In this case, the device 1 operates in card emulation mode. Still during such a communication, a transmission of data from the device 1 to the device 2 is performed by the device 1 by modulating the load formed by the device 1 on the filed radiated by the device 2, the latter interpreting (demodulating) this load variation.

When the two devices are not currently communicating, the circuits and/or the functions of the devices 1 and 2 used for near field communication are switched in stand by mode or low power mode. When one device, for example the device 1, emits an electromagnetics field to detect whether another device, for example the device 2, is in its range and that a communication between the devices can be implemented, the field emitted by the device 1 is picked up (e.g. detected) by the circuits of the device 2 which, if they are on standby, are reactivated. That is reflected in a variation of the load of the circuits of the device 2 on the resonant circuit for generating the field of the device 1. In practice, the corresponding variation of the phase and/or amplitude of the field emitted is detected by the device 1. In this case, the device 1 is operating in tag detection mode. For example, on the device 1 side, when the amplitude of the voltage at the terminals of the resonant circuit dropping below a threshold or a phase shift above a threshold is detected, the device 1 detects that the device 2 is in its range. Once the device 2 is detected by device 1, the device 1 then begins a near field communication protocol with the device 2.

The device 1 has to extract data from a subcarrier signal on top of the carrier signal whereas the amplitude of the subcarrier signal is small with respect to the amplitude, when the device 1 operates in terminal unit reader mode, or, said otherwise, when the device 1 receives data via the carrier field it emits. Further, the device 1 has to detect a variation of the phase and/or the amplitude of its emitted field without receiving data in the form of bits when operating in tag detection mode. Finally, the device 1 has to detect a modulation of a received carrier field emitted by another device when the device 1 operates in card emulation mode. More particularly, in card emulation mode, the device 1 has to amplify a small carrier signal compared to a large carrier signal received in terminal unit reader mode or tag detection mode, with a large modulation of the carrier signal compared to the small modulation of the carrier signal in terminal unit reader mode.

Thus, the device 1 generally comprises a first circuit for receiving data via a carrier field radiated by device 1 when operating in terminal unit mode, a second circuit for detecting a radiofrequency device via the carrier field radiated by the device 1 when operating in tag detection mode, and a third circuit for receiving data via a carrier field radiated by another device when operating in card emulation mode. These three circuits are generally distinct circuits, which leads to a large area, complexity and consumption.

It has been proposed, for example, in the European patent EP 3672091 B1 and US patent US 11228344 B2, a radiofrequency device comprising a first circuit for implementing both the terminal unit reader mode and the tag detection. In such a device, a second circuit, distinct from the first one, is still required to implement the card emulation mode.

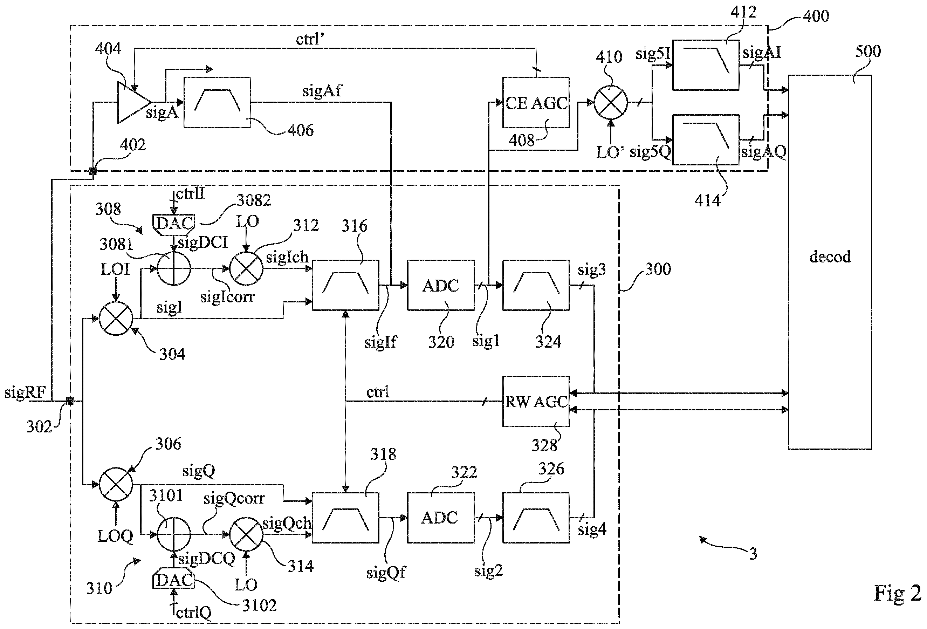

Figure 2 illustrates an example of a radiofrequency device 3 capable of operating in each of the three operating modes previously described.

In Figure 2, the device 3 is only partially represented. Indeed, only the elements and circuits which are used for implementing the three above described operating modes are represented. Other circuits and element are of course present in the device 3, for example to emit a radiofrequency field when operating in tag detection mode, and for example to emit the radiofrequency field when operating in terminal unit mode and modulate the emitted radiofrequency field for transmitting data to another device in terminal unit writer mode. More particularly, the part of the device 3 for generating the electromagnetic field is not represented, only the receiving part being represented.

The device 3 comprises a first circuit 300 and a second circuit 400 distinct from the first one.

The circuit 300 comprises an input 302 configured to receive a radiofrequency signal in the first and second operating modes (terminal unit reader mode and tag detection mode). The circuit 400 comprises an input 402 configured to receive a radiofrequency signal sigRF in the third operating mode (card emulation mode).

The circuit 400 comprises an input 402 configured to receive the radiofrequency signal sigRF in the third operating mode (card emulation mode).

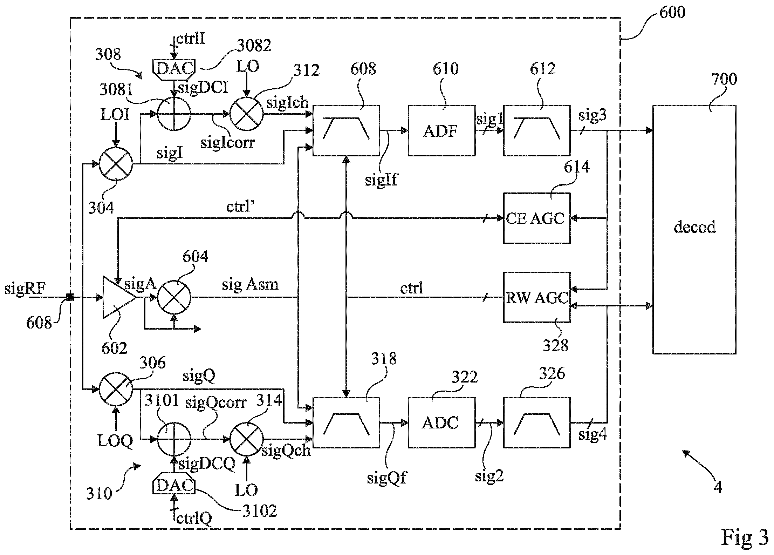

In practice, although not shown on Figure 3, the signal sigRF provided to inputs 302 and 402 is received by an antenna of the device 3. Front-end circuits (not shown on Figure 2) may be provided between the antenna and the inputs 302 and 402. These front-end circuits may include, depending on the application, matching network(s), splitting circuits (in case the antenna is common for transmitting and receiving parts), filters, etc.

The circuit 300 comprises a mixer 304 and a mixer 306. The two mixers 304 and 306 implement and In-phase/Quadrature downconverter or IQ downconverter. The IQ downconverter is controlled at a frequency fc, for example 13.56 MHz, which corresponds to the nominal frequency of the carrier of the radiofrequency signal sigRF. The IQ downconverter provides two DC signals sigI and sigQ.

More specifically, the mixer 304 is configured, in the first and second operating modes, to receive the radiofrequency signal sigRF, to mix the signal sigRF with a periodic signal LOI at the frequency fc and, for example, in-phase with the carrier of the signal sigRF, and to output the signal sigI. The mixer 306 is configured, in the first and second operating modes, to receive the radiofrequency signal sigRF, to mix the signal sigRF with a periodic signal LOQ at the frequency fc and in quadrature with the signal LOI, and to output the signal sigQ.

The circuit 300 comprises a circuit 308 and a circuit 310. The circuit 308 is configured, in the second operating mode, to receive the output sigI of the mixer 304, to apply, preferably to subtract, a DC signal sigDCI to the signal sigI, and to output a signal sigIcorr corresponding to the signal sigI to which the signal sigDCI has been applied. Similarly, the circuit 310 is configured, in the second operating mode, to receive the output sigQ of the mixer 306, to apply, preferably to subtract, a DC signal sigDCQ to the signal sigQ, and to output a signal sigQcorr corresponding to the signal sigQ to which the signal sigDCQ has been applied.

The circuits 308 and 310 are configured to apply a DC correction to the output signals sigI and sigQ of the IQ downconverter.

For example, circuit 308 comprises a subtractor circuit 3061. The circuit 3081 is configured, in the second operating mode, to receive the signals sigI and sigDCI, to subtract the DC signal sigDCI to the signal sigI, and to output the resulting signal sigIcorr. For example, the circuit 308 comprises a digital to analog converter 3082 (block DAC on Figure 2) configured to receive a digital control signal ctrlI and to output the analog DC signal sigDCI.

For example, circuit 310 comprises a subtractor circuit 3101. The circuit 3101 is configured, in the second operating mode, to receive the signals sigQ and sigDCQ, to subtract the DC signal sigDCQ to the signal sigQ, and to output the resulting signal sigQcorr. For example, the circuit 310 comprises a digital to analog converter 3102 (block DAC on Figure 2) configured to receive a digital control signal ctrlQ and to output the analog DC signal sigDCQ.

The circuit 300 comprises a mixer 312 and a mixer 314. The mixer (or chopper circuit) 312 is configured, in the second operating mode, to receive the output signal sigIcorr, to mix (or multiply) the signal sigIcorr with a signal LO at a chopping frequency fchop, and to output a resulting signal sigIch. The mixer (or chopper circuit) 314 is configured, in the second operating mode, to receive the output signal sigQcorr, to mix (or multiply) the signal sigQcorr with the signal LO, and to output a resulting signal sigQch. Preferably, the frequency fchop corresponds to the frequency used by a card device to communicate with device 3 when device 3 emits the carrier, i.e. to the frequency of the subcarrier of back modulation. An advantage of the circuits 312 and 314 is that it reduces the flicker noise due to the card activation. As an example, the chopping frequency fchop is equal to 847.5 kHz.

The circuit 300 comprises an analog filter 316 and an analog filter 318. In the example, the filter 316 is a bandpass filter configured to apply a bandpass filtering to the signal sigI in the first operating mode, and to the signal sigIch in the second operating mode. The filter 316 outputs a filtered signal sigIf. In the example, the filter 318 is a bandpass filter, for example identical to the bandpass filter 316, configured to apply a bandpass filtering to the signal sigQ in the first operating mode, and to the signal sigQch in the second operating mode. The filter 318 outputs a corresponding filtered signal sigQf. For example, the filters 316 and 318 are centered on a frequency lower than the carrier frequency fc. These filters are for example centered on the frequency of the subcarrier, or, said otherwise, the frequency of the subcarrier signal or of the back-modulation.

The signals sigIf and sigQf are signals representative of the phase and the amplitude of the signal sigRF.

For example, the DC levels sigDCI and sigDCQ are determined by the DC levels on the outputs of the respective filters 316 and 318 when no card in present in the field radiated by device 3, such that, in the first and second operating modes the signal sigIf and sigQf correspond to the actual phase and amplitude of the signal sigRF. Eliminating the DC static or DC noise component allows to amplify with filters 316 and 318 only the useful signals before submitting the signal sigIf and sigQf to an analog-to-digital conversion.

The circuit 300 comprises an analog-to-digital converter 320 and an analog-to-digital converter 322. The analog-to-digital converter 320 is configured to perform, in the first and second operating modes, an analog-to-digital conversion of the signal sigIf and to output the resulting digital signal sig1. The analog-to-digital converter 322 is configured to perform, in the first and second operating modes, an analog-to-digital conversion of the signal sigQf and to output the resulting digital signal sig2.

The circuit 300 comprises a digital filter 324 and a digital filter 326. In the example, the digital filters 324 and 326 are bandpass filters identical to each other. Filter 324 is configured, in the first and second operating modes, to receive the output sig1 of the converter 320, to apply a bandpass filtering to the signal sig1, and to output a resulting filtered signal sig3. Filter 326 is configured, in the first and second operating modes, to receive the output sig2 of the converter 322, to apply a bandpass filtering to the signal sig2, and to output a resulting filtered signal sig4. As an example, the filters 324 and 326 are centered on a frequency lower than the carrier frequency fc. These filters are for example centered on the frequency of the subcarrier, or, said otherwise, the frequency of the subcarrier signal or of the back-modulation.

In the first and second operating modes, the gains of the filters 316 and 318 is controlled by a control signal ctrl. For example, the circuit 300 comprises a control circuit 328 (block RW AGC) configured to control the gains of the filters 316 and 318, the circuit 328 outputting the signal ctrl. For example, the circuit 328 receives the signal sig3 and controls the gain of the filter 316 based on the signal sig3. For example, the circuit 328 receives the signal sig4 and controls the gain of the filter 318 based on the signal sig4.

In the circuit 300, the elements 304, 306 308, 310 316 and 318 implement, in the second operating mode, a circuit similar to the circuit 3' represented in Figure 5 of the above mentioned European and US patents.

The signals sig3 and sig4 are outputted by the circuit 300 and provided to a digital circuit 500 (bloc decod in Figure 2).

In the first operating mode, the circuit 500 is configured extract data from the signals sig3 and sig4, the data being sent by a card to the device 3 via a modulation of the carrier field radiated by the device 3. Said otherwise, in the first operating mode, the circuit 500 is configured to use signal sig3 and sig4 for extracting data from a subcarrier signal added by a card on top of the carrier field radiated by the device 3.

In the second operating mode, the circuit 500 is configured to detect whether a device is in the carrier field radiated by the device 3 based on the signals sig3 and sig4.

The circuit 400 comprise a gain controllable amplifier 404. The amplifier 402 is configured, in the third operating mode, to receive the signal sigRF and to provide a corresponding amplified signal sigA. The gain of the amplifier 404 is controlled by a signal ctrl'.

Although not shown on Figure 2, the signal sigA may be provide to a circuit configured to extract a clock signal, for example at the carrier frequency fc, from the signal sigA.

The circuit 400 comprise an analog filter 406. The filter 406 is a bandpass filter. The filter 406 is configured, in the third operating mode, to receive the signal sigA, to apply a bandpass filtering to the signal sigA, and to output a corresponding filtered signal sigAf. The filter 406 is, for example, centered on the carrier frequency fc.

An analog-to-digital conversion of the signal sigAf is then performed by an analog-to-digital converter of the device 3. In the example, the analog-to-digital converter configured to perform the analog-to-digital conversion of the signal sigAf is the converter 320 of the circuit 300. Thus, the converter 320 is configured, in the third operating mode, to receive the signal sigAf, and to output the digital signal sig1 resulting from the analog-to-digital conversion of the signal sigAf.

The circuit 400 comprise a control circuit 408 (block CE AGC in Figure 2). The circuit 408 is configured, in the third operating mode, to control the gain of the amplifier 404 based on the signal sig1. The circuit 408 is configured to receive, in the third operating mode, the signal sig1, and to output the signal ctrl' for controlling the gain of the amplifier 404. The signal ctrl' is determined, in the third operating mode, by the signal sig1.

The circuit 400 comprises a digital IQ downconverterr 410. The IQ downconverter 410 is controlled at a frequency fc of the carrier of the radiofrequency signal sigRF. Said otherwise, the IQ downconverter is controlled by a digital periodic signal LO' at the frequency fc. The IQ downconverter 410 is configured, in the third operating mode, to mix the signal sig1 with the signal LO', thus providing a signal sig5I, and to mix the signal sig1 with a signal in quadrature with signal LO', thus providing a signal siq5Q.

The circuit 400 comprises a digital filter 412 and a digital filter 414. The filters 412 and 414 are lowpass filters. The filter 412 is configured, in the third operating mode, to apply a bandpass filtering to signal sig5I, and to output a resulting filtered signal sigAI. The filter 414 is configured, in the third operating mode, to apply a bandpass filtering to signal sig5Q, and to output a resulting filtered signal sigAQ.

The two digital signals sigAI and sigAQ are outputted by the circuit 400, and provided to the circuit 500.

The circuit 500 is configured, in the third operating mode, to extract data from the received signal sigRF, or said otherwise, to extract data from the subcarrier on top of the carrier signal of the signal sigRF.

For example, the circuit 500 is configured, in the third operating mode, to implements a cordic algorithm on the signals sigAI and sigAQ. For example, the circuit 500 is further configured to extract data from two signals outputted by the cordic algorithm in case the back modulation is an OOK modulation, and/or to extract data from the two signals outputted by the cordic algorithm in case the back modulation is an ASK modulation. For example, the circuit 500 is further configured to extract data from ASK modulation with a subcarrier, or, said in other words, to extract data from the signal sigRF when an ASK modulation with subcarrier has been performed on the signal sigRF. Preferably, the circuit 500 is able to simultaneously begin the decoding of signal sigRF with the three types of modulation of the signal sigRF, that is an OOK modulation of signal sigRF, an ASK modulation of signal sigRF and an ASK with subcarrier modulation of signal sigRF, and to determine the communication protocol and the data rate from the modulation type.

Although the circuits 300 and 400 have the converter 320 in common, or, said otherwise, share the converter 320, the circuit 400 still have a lot of distinct circuits with respect to the circuit 300.

Moreover, in the third operating mode, the converter 320 has to perform the analog-to-digital conversion of the signal sigAf at an operating frequency which cannot be lower than four times the carrier frequency fc. This is due to the fact that, in the third operating mode, the converter 320 directly samples the amplified carrier of the signal sigAf. Thus, even if in the first and second operating modes the converter 320 (and the converter 322) operates at a lower operating frequency which can be minimal when equal to twice the carrier frequency fc, the converter 320 has to support an operating frequency at least equal to four times the carrier frequency for the third operating mode. As the result, the complexity, the area and the consumption of the converter 420 is increased with respect to an analog-to-digital converter operating at a lower operating frequency, for example at twice the carrier frequency.

It is here proposed a circuit in which, in the third operating mode, the signal sigRF is amplified and the resulting amplified signal is mixed with itself. This allows to reuse at least some element of the circuit 300. In particular, it allows to make the analog-to-digital conversion, in the third operating mode, at a frequency which can be as low as twice the carrier frequency fc. Indeed, by self-mixing the amplified received signal, the sampling for the analog-to-digital conversion is made on the envelop of the carrier rather than on the carrier itself as it is the case in the device 3.

Figure 3 illustrates an example embodiment of a radiofrequency device 4 capable of operating in each of the three operating modes previously described.

The device 4 comprises a circuit 600. The circuit 600 comprises many elements in common with the circuit 300 of the device 3 of Figure 2, and only the differences between circuits 600 and 300 are here highlighted.

The device 4 does not comprise the circuit 400 of the device 3. In replacement of the circuit 300, the circuit 600 of device 4 comprises a gain controllable amplifier 602, similar to the amplifier 404 (Figure 2) and a mixer 604.

The amplifier 602 is configured to receive, in the third operating mode, the signal RF received on an input 606 the circuit 600, and to provide a corresponding amplified signal sigA. The gain of the amplifier 602 is controlled by a signal ctrl'.

The mixer 604 is configured to receive the signal sigA, to mix (or multiply) the signal sigA with itself, and to provide a signal sigAsm resulting of the self-mixing of the signal sigA.

In practice, although not shown on Figure 3, the signal sigRF provided to input 606 is received by an antenna of the device 4. Front-end circuits (not shown on Figure 3) may be provided between the antenna and the input 606. These front-end circuits may include, depending on the application, matching network(s), splitting circuits (in case the antenna is common for transmitting and receiving parts), filters, etc.

Furthermore, although not shown on Figure 3, the signal sigA may be provide to a circuit configured to extract a clock signal, for example at the carrier frequency fc, from the signal sigA.

As the circuit 300, the circuit 600 comprises the mixers 304 and 306, or, said otherwise, the IQ downconverter.

As the circuit 300, the circuit 600 comprises the circuits 308 and 310 for applying the DC correction to the signals sigI and sigQ. For example, the circuit 308, respectively 310, comprises the circuit 3081, respectively 3101. For example, the circuit 308, respectively 310, comprises the digital-to-analog converter 3082, respectively 3102 configured to receive the digital control signal ctrlI, respectively ctrlQ, and to output the analog DC signal sigDCI, respectively sigDCQ.

As the circuit 300, the circuit 600 comprises the mixers 312 and 314.

As the circuit 300, the circuit 600 comprises the analog filter 318. The bandpass filter 318 is configured to apply a bandpass filtering to the signal sigQ in the first operating mode, and to the signal sigQch in the second operating mode. Further, according to one embodiment, the bandpass filter is configured to apply the bandpass filtering to the signal sigAsm is the third operating mode. The filter 318 outputs a corresponding filtered signal sigQf. For example, the filter 318 is centered on a frequency lower than the carrier frequency fc. The filter 318 is, for example, centered on the frequency of the subcarrier, or, said otherwise, the frequency of the subcarrier signal or of the back-modulation.

In the circuit 600, the analog filter 316 of the circuit 300 is replaced by a reconfigurable analog filter 608. The filter 608 is configured to apply a bandpass filtering to the signal sigI in the first operating mode, and to the signal sigIch in the second operating mode. In the first and second operating modes, the bandpass filter 608 is centered on a frequency lower than the carrier frequency fc, for example the frequency of the subcarrier. The filter 608 is further configured to apply a low pass filtering to the signal sigAsm in the third operating mode. For example, in the third operating mode, the cutoff frequency of the filter 608 is set to a frequency high enough to follow the carrier envelope during OOK and ASK modulation, which is, for example, around 3 MHz.

In the first and second operating modes, the signals sigIf and sigQf are signals representative of the phase and the amplitude of the signal sigRF, as in circuit 300. However, in the third operating mode, the signal sigIf is representative of the envelope of the signal sigRF, and the signal sigQf is representative of the subcarrier of the signal sigRF.

The circuit 600 further comprises the analog-to-digital converter 322. The analog-to-digital converter 322 is configured to perform, in the first and second operating modes, an analog-to-digital conversion of the signal sigIf and to output a resulting digital signal sig2. Furthermore, in one embodiment where the converter 322 receives the signal sigAsm in the third operating mode, the converter 322 is configured to perform, in the third operating mode, the analog-to-digital conversion of the signal sigIf, and to output the resulting digital signal sig2.

However, the analog-to-digital converter 320 is replaced by an analog-to-digital converter 610. The analog-to-digital converter 610 is configured to perform an analog-to-digital conversion of the signal sigIf in the first and second operating modes, and an analog-to-digital conversion of the signal sigIf in the third operating mode. The converter 610 output the resulting digital signal sig1.

In the third operating mode, compared to the analog-to-digital converter 320 which has to perform the analog-to-digital conversion of the signal sigAf at an operating frequency which cannot be lower than four times the carrier frequency fc, the analog-to-digital converter 610 perform the analog-to-digital conversion of the signal sigIf at a lower frequency, for example at a frequency equal to twice the carrier frequency. For example, the operating frequency of the converter 320 is high enough to be superior or equal to twice the bandwidth of the analog filters 608, 318, or, said in other words to be superior or equal to twice the highest bandwidth of the analog filters 608, 318 of the three operating modes.

Thus, the converter 610 can operate, in the third operating mode, at a lower operating frequency than the converter 320. It follows that the converter 608 is simpler than converter 320, takes less area than converter 320 and has a lower consumption than converter 320.

This results from the fact that, in the third operating mode, the signal sigAsm resulting from the self-mixing of the signal sigA is used rather than the signal sigAf.

For example, the converter 610 is identical to converter 322. For example, in the third operating mode, both converters 610 and 322 operates at the same operating (or sampling) frequency. For example, the converters 610 and 322 operate at the same operating frequency, whatever is the current operating mode selected among the first, second and third operating modes.

As the circuit 300, the circuit 600 comprises the digital filter 326. The bandpass filter 326 is configured, at least in the first and second operating mode, to receive the output sig2 of the converter 322, to apply a bandpass filtering to the signal sig2, and to output the resulting filtered signal sig4. According to one embodiment where, in the third operating mode, the filter 318 applies a bandpass filtering to the signal sigAsm, the filter 326 is further configured, in the third operating mode, to apply the same bandpass filtering to the signal sig2 than in the first and second operating modes, and to output the resulting signal sig4.

However, the digital filter 324 is replaced by a reconfigurable digital filter 612. The filter 612 is configured, in the first and second operating modes, to receive the output sig1 of the converter 610, to apply a bandpass filtering to the signal sig1, and to output the resulting filtered signal sig3, as it was the case of the filter 324 in device 3. The filter 612 is further configured, in the third operating mode, to receive the signal sig1, to apply a low pass filtering to signal sig1, and to output the resulting filtered signal sig3.

For example, the bandpass filtering performed by the digital filters 612 and 326 are centered on the subcarrier frequency, and the low pass filtering performed to the filter 612 in the third operating mode corresponds to the bandpass filtering performed by filter 612 in first and second operating modes but without the high-pass filtering.

In a same way as what has been described for the filters 316 and 318 of the device 3, in the first and second operating modes, the gains of the filters 608 and 318 is controlled by a control signal ctrl. For example, the circuit 600 comprises the control circuit 328 (block RW AGC) configured to control the gains of the filters 616 and 318, the circuit 328 outputting the signal ctrl. For example, the circuit 328 receives the signal sig3 and controls the gain of the filter 608 based on the signal sig3 in the first and second operating modes. For example, the circuit 328 receives the signal sig4 and controls the gain of the filter 318 based on the signal sig4 in the first and second operating modes. For example, in the third operating mode, the gain of the filters 608 and 318 is set, for example via the signal ctrl, to a default value.

The circuit 600 comprise a control circuit 614 (block CE AGC in Figure 3). The circuit 614 is configured, in the third operating mode, to control the gain of the amplifier 602 based on the signal sig3. The circuit 614 is configured to receive, in the third operating mode, the signal sig3, and to output the signal ctrl' for controlling the gain of the amplifier 602. The signal ctrl' is determined, in the third operating mode, by the signal sig3.

The signals sig3 and sig4 are outputted by the circuit 600 and provided to a digital circuit 700 (bloc decod in Figure 3).

In the first operating mode, the circuit 700 is configured extract data from the signals sig3 and sig4, the data being sent by a card to the device 4 via a modulation of the carrier field radiated by the device 4. Said otherwise, in the first operating mode, the circuit 700 is configured to use signal sig3 and sig4 for extracting data from a subcarrier signal added by a card on top of the carrier field radiated by the device 4. For example, the circuit 700 is configured to perform a subcarrier ASK decoding based on the signals sig3 and sig4 in the first operating mode.

In the second operating mode, the circuit 700 is configured to detect whether a device is in the carrier field radiated by the device 4 based on the signals sig3 and sig4.

In the third operating mode, the circuit 700 is configured to extract data from the signal sig3, the data being sent by a device operating as a terminal which emits the electromagnetic field and modulates the radiated field, for example using ASK or OOK modulation, based on the data to transmit. More particularly, the data are extracted from the envelope of the signal sigRF, or, said otherwise, from the signal sig3 which is representative of the envelope of the signal sigRF.

For example, the circuit 700 is configured, in the third operating mode, to perform at least one among an OOK decoding or an ASK decoding of the received signal sigRF, based on the signal sig3.

In one embodiment where, in the third operating mode, the signal sigAch is provided to filter 318 in order to obtain signal sig4 at the output of filter 326, the circuit 700 is further configured to extract the subcarrier from the signal sig4, for example to extract the subcarrier frequency from signal sig4. This is for example useful when the device 4 has to send data to the device which emits the electromagnetic field and has to synchronized the modulation the device 4 performs on the electromagnetic field with the subcarrier of the signal sigRF. This is for example the case in Japan.

For example, when the signal sg4 is provided in the third operating mode, the circuit 700 is configured to further perform, in the third operating mode, a subcarrier ASK decoding based on the signals sig3 and sig4.

In the above described embodiment, the filter 318, the converter 322 and the filter 326 are used in the third operating mode in order to produce the signal sig4 not only in the first and second operating modes, but also in the third operating mode. However, in alternative embodiments, the signal sig4 in not required by the device 4 in the third operating mode, and the circuits 318, 322, 326 may be unused, for example may be switched to a standby or low power mode.

As an example, the mixers 304, 306 and 604 may be commutative mixers with low pass filters.

As an example, the preamplifier 602 is a fully differential first order lowpass active filter, for example implemented with a fully differential amplifier.

As an example, the converter 610 and 322 are SAR (Successive Approximation Register) ADC (Analog to Digital Converter) with a sampling (or operating) frequency for example equal to the twice the carrier frequency fc, providing each of the output signals sig1 and sig2 as a digital word including a plurality of bits.

As an example, the analog filters 318 and 608 are three-stages active filters, respectively corresponding to a bandpass filter, a lowpass filter and a bandpass filter, of the second order for each stage, with single or multiple feedback topology for each stage.

As an example, in the first operating mode, the analog filters 608 and 318 have a gain superior to 50 dB at in the range of frequencies in which a subcarrier frequency is selected, for example in the range from 212 to 848 kHz. Said otherwise, the bandpass of the filter 608 and 318 in the first operating mode is for example approximatively equal to a range of frequencies corresponding to the possible frequencies of the subcarrier.

As an example, in the second operating mode, the analog filters 608 and 318 have a gain superior to 40 dB at the chopping frequency of the signal LO.

As an example, in the third operating mode, the analog filter 608 has a configurable gain superior to 25 dB at the carrier frequency fc.

As an example, the digital filters 612 and 326 may be implemented as Finite Impulse Response (FIR) filters, or Infinite Impulse Response (IIR) filters.

An advantage of the device 4 compared to the device 3 is to have a reduced area, as the same filters and ADC converters are used in the three operating modes.

An advantage of the device 4 compared to the device 3 is to have a reduced consumption, as the converter 610 operates at a lower frequency than the converter 320, which is also the case of the digital processing comprising, for example, the filters 612 and 326 and the circuit 700.

Another advantage of the device 4 compared to the device 3 is to work, in the third operating mode, with different carrier frequencies thanks to the self-mixing of the signal sigA, whereas the circuit 400 is design for only one specified carrier frequency.

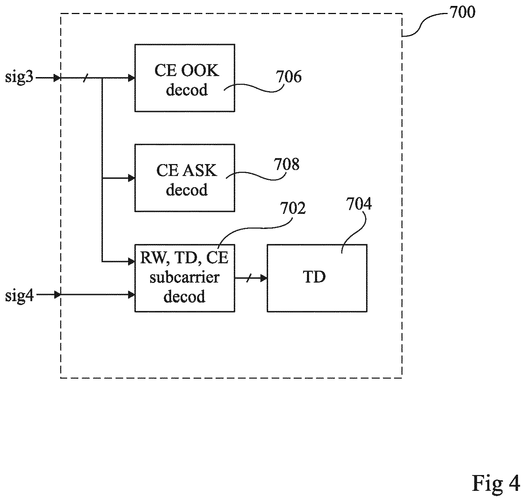

Figure 4 illustrates in the form of blocks an example of a detailed embodiment of the decoding digital circuit 700 of the device 4 of Figure 3.

The circuit 700 receives the signals sig3 and sig4 in the first and second operating modes.

The circuit 700 is configured, in the first and second operating modes, to perform an ASK subcarrier decoding of the signal sigRF (figure 3) based on the signals sig3 and sig4, as illustrated in Figure 4 by a functional block 702 (RW, TD, CE subcarrier decode). The block 702 receives both signals sig3 and sig4.

The circuit 700 is further configured, in the second operating mode, to detect whether a device acting as a card is in the range of the device 4, or, said otherwise, is in the electromagnetic field radiated by the device. This is for example implemented with a state machine receiving the outputs of the functional bloc 702, and providing an active flag when such a device is detected. The state machine is represented by a functional block 704 (TD) in Figure 4.

The circuit 700 is further configured, in the third operating mode, to perform an ASK decoding and/or an OOK decoding based on the signal sig3. For example, the circuit 700 comprises a functional block 706 (CE OOK decod) configured to receive the signal sig3 and to implement the OOK decoding of the signal sigRF based on the signal sig3. For example, the circuit 700 comprises a functional block 708 (CE ASK decod) configured to receive the signal sig3 and to implement the ASK decoding of the signal sigRF based on the signal sig3.

In one embodiment where the signal sig4 is provided to circuit 700 in the third operating mode, the circuit 700 is further configured, in the third operating mode, to extract the subcarrier from the signal sig4. In this case, the block 702 is reused in the third operating mode to implement the subcarrier ASK decoding based on signal sig3 and sig4.

As an example, in the circuit 700 of Figure 3 or 4, the OOK decoding of the third operating mode is implemented based on a rising edge detector with a selectable threshold, for example based on an IIR filter with a comparator.

As an example, in the circuit 700 of Figure 3 or 4, the ASK decoding of the third operating mode is implemented based on an edge detector with a selectable threshold, for example based on an IIR filter with comparators.

As an example, in the circuit 700 of Figure 3 or 4, the subcarrier decoding is implemented with a digital correlation system based on Costas loop.

Various embodiments and variants have been described. Those skilled in the art will understand that certain features of these embodiments can be combined and other variants will readily occur to those skilled in the art.

In particular, although the device 4 has been described as being part of a device such as a mobile phone, for example to use the mobile phone as a payment card or as an access card in the third operating mode, and as an NFC terminal in the first and second operating modes, the device 4 may be implemented in electronic systems other than mobile phone where the three operating modes described previously are needed. For example, such an electronic system could be a so-called Internet of Things (IoT) electronic device using NFC for communication. An additional example would be smart appliances, where NFC communications are used between various modules to transfer settings, select the operating mode or check for part authenticity. Furthermore, the present disclosure is not limited to the NFC technologies, and could be applied to other technologies where the three described operating modes are implemented.

Finally, the practical implementation of the embodiments and variants described herein is within the capabilities of those skilled in the art based on the functional description provided hereinabove. In particular, those skilled in the art are capable to implement each of the described circuits of the device 4, based on the functional description made of these circuits in the present description.

## Claims

1. A radiofrequency device (4) comprising:
a first mixer (304) configured, in first and second operating modes, to mix a received radiofrequency signal (sigRF) with a first periodic signal (LOI) having a frequency equal to a frequency of a carrier of the received radiofrequency signal (sigRF);
a second mixer (306) configured, in the first and second operating modes, to mix the received radiofrequency signal (sigRF) with a second periodic signal (LOQ) having a frequency equal to the frequency of the carrier and being in quadrature with first periodic signal (LOI);
a gain controllable amplifier (602) configured, in a third operating mode, to provide an amplified signal (sigA) of the received radiofrequency signal (sigRF); and
a third mixer (604) configured, in the third operating mode, to mix the amplified signal (sigA) with itself.

2. The radiofrequency device of claim 1, wherein the first operating mode is a reader mode, preferably a terminal unit reader mode, the second operating mode is a tag detection mode, and the third operating mode is a card emulation mode.

3. The radiofrequency device of claim 1 or 2, wherein the radiofrequency device (4) further comprises:
a first circuit (308) configured, in the second operating mode, to apply a first DC component (sigDCI) to an output signal (sigI) of the first mixer (304);
a fourth mixer (312) configured, in the second operating mode, to mix an output (sigIcorr) of the first circuit (308) with a third periodic signal (LO) having a frequency equal to a chopping frequency;
a second circuit (310) configured, in the second operating mode, to apply a second DC component (sigDCQ) to an output signal (sigQ) of the second mixer (306); and
a fifth mixer (314) configured, in the second operating mode, to mix an output (sigDCcorr) of the second circuit (310) with the third periodic signal (LO).

4. The radiofrequency device of claim 3, wherein the radiofrequency device (4) further comprises:
a first reconfigurable analog filter (608) configured to:
- apply a bandpass filtering to the output (sigI) of the first mixer (304) in the first operating mode and to an output (sigIch) of the fourth mixer (312) in the second operating mode, and
- apply a lowpass filtering to an output (sigAsm) of the third mixer (604) in the third operating mode; and
a second analog filter (318) configured to apply a bandpass filtering to the output (sigQ) of the second mixer (306) in the first operating mode and to an output (sigQch) of the fifth mixer (314) in the second operating mode.

5. The radiofrequency device of claim 4, wherein the radiofrequency device (4) further comprises:
a first analog-to-digital converter (610) configured to provide a first digital signal (sig1) resulting from an analog-to-digital conversion of an output (sigIf) of the first analog filter (608);
a second analog-to-digital converter (322) configured to provide a second digital signal (sig2) resulting from an analog-to-digital conversion of an output (sigQf) of the second analog filter (318);
a first reconfigurable digital filter (612) configured to:
- apply a bandpass filtering to the first digital signal (sig1) in the first and second operating modes, and
- apply a lowpass filtering to the first digital signal (sig1) in the third operating mode; and
a second digital filter (326) configured to apply a bandpass filtering to the second digital signal (sig2).

6. The radiofrequency device of claim 5, wherein the first and second analog-to-digital converters (610, 322) are configured to operate at a same sampling frequency in the first, second and third operating modes, for example less or equal to twice the frequency of the carrier.

7. The radiofrequency device of claim 5 or 6, wherein the radiofrequency device (4) further comprises:
a first control circuit (328) configured, in the first and second operating modes, to control a gain of the first configurable analog filter (608) and a gain of the second analog filter (318), based on the output of the first configurable digital filter (sig3) and an output of the second digital filter (sig4); and
a second control circuit (614) configured, in the third operating mode, to control a gain of the gain controllable amplifier (602) based on the output of the first configurable digital filter (sig3).

8. The radiofrequency device of any of claims 5 to 7, wherein the radiofrequency device (4) further comprises a digital decoding circuit (700) configured to:
perform a subcarrier Amplitude Shift Keying decoding of the received radiofrequency signal (sigRF) based on the output signal (sig3) of the first reconfigurable digital filter (612) and the output signal (sig4) of the second digital filter (326) in the first operating mode;
indicate whether or not a radiofrequency device is detected based on the output signals (sig3, sig4) of the first and second digital filters (612, 326) in the second operating modes; and
perform at least one among an On-Off Keying decoding and an Amplitude Shift Keying decoding of the received radiofrequency signal (sigRF) based on the output signal (sig3) of the first reconfigurable digital filter (612) in the third operating mode.

9. The radiofrequency device of claim 4, wherein the second analog filter is further configured to apply the bandpass filtering to the output (sigAsm) of the third mixer (604) in the third operating mode.

10. The radiofrequency device of claim 5, wherein:
the second analog filter (318) is further configured to apply the bandpass filtering to the output (sigAsm) of the third mixer (604) in the third operating mode; and
the second digital filter (326) is further configured to apply the bandpass filtering to the second digital signal (sig2) in the third operating mode.

11. The radiofrequency device of claim 8, wherein:
the second analog filter (318) is further configured to apply the bandpass filtering to the output (sigAsm) of the third mixer (604) in the third operating mode;
the second digital filter (326) is further configured to apply the bandpass filtering to the second digital signal (sig2) in the third operating mode; and
the digital circuit (700) is further configured to perform a subcarrier Amplitude Shift Keying decoding of the received radiofrequency signal (sigRF) based on the output signals (sig3, sig4) of the first and second digital filters (612, 326) in the third operating mode.

12. The radiofrequency device of any of claims 3 to 11, wherein the chopping frequency is 847.5 kHz.

13. The radiofrequency device of any of claims 1 to 12, wherein the frequency of the carrier is 13.56 MHz.

14. The radiofrequency device of any of claims 1 to 13, wherein the radiofrequency device (4) further comprises a circuit configured, in the third operating mode, to extract a clock signal from the amplified signal (sigA).

15. A mobile phone comprising the radiofrequency device of any of claims 1 to 14.
